# EUROPEAN PATENT APPLICATION

(11) **EP 3 565 389 A1**
(43) Date of publication of application: **06.11.2019**
(21) Application number: 17887641.3
(22) Date of filing: 25.12.2017
(51) Int. Cl.: H05K 1/14, G06F 3/041, G06F 3/044

(54) **WIRING BODY ASSEMBLY, WIRING SUBSTRATE, AND TOUCH SENSOR**

(30) Priority: 28.12.2016 JP 2016256473; 28.12.2016 JP 2016256479
(71) Applicant: Fujikura Ltd., Tokyo 135-8512 (JP)
(72) Inventor: SUTO, Yuki, Sakura-shi Chiba 285-8550 (JP)
(74) Representative: Ter Meer Steinmeister & Partner
(86) International application number: PCT/JP2017/046440
(87) International publication number: WO 2018/123976

(57) **Abstract**

A wiring body assembly 40 includes: a first wiring body 50 including a first resin portion 51 and a first lead wiring 522 and a first terminal portion 523 formed on an upper surface of the first resin portion; a second wiring body 60 including a substrate 61 and a third lead wiring 621 and a third terminal portion 622 formed on a lower surface of the substrate; and a conductive adhering portion 70 connecting the first terminal portion and the third terminal portion. The first wiring body and the second wiring body overlap each other so that the first terminal portion and the third terminal portion face each other via the conductive adhering portion, the conductive adhering portion includes a first protruding portion 701 protruding from a space between the first wiring body and the second wiring body, the first protruding portion covers a portion of an end surface 501 of the first wiring body, and a portion of the end surface of the first wiring body includes at least a region overlapping the second wiring body in a stacking direction of the first wiring body and the second wiring body.

## Description

### TECHNICAL FIELD

The present invention relates to a wiring body assembly including two wiring bodies connected by a conductive adhering portion, a wiring board, and a touch sensor.

For designated countries that are permitted to be incorporated by reference in the literature, the contents described in Japanese Patent Application No. 2016-256473 filed in Japan on December 28, 2016 and Japanese Patent Application No. 2016-256479 filed in Japan on December 28, 2016 are incorporated herein by reference and are regarded as a part of the description of this specification.

### BACKGROUND ART

It is known that, in a printed wiring board connection structure by connecting two or more printed wiring boards by using an anisotropic conductive adhesive, a cover layer of each printed wiring board is cut out to expose a connection electrode portion (refer to, for example, Patent Document 1).

### CITATION LIST

### PATENT DOCUMENT

Patent Document 1: JP 2011-253979 A

### SUMMARY OF THE INVENTION

### PROBLEM TO BE SOLVED BY THE INVENTION

In the printed wiring board connection structure , the anisotropic conductive adhesive is disposed between the two printed wiring boards so as to connect the exposed connection electrodes to each other. In this case, there is a problem that stress concentrates on the periphery of the region where the two printed wiring boards overlap, so that the two printed wiring boards are easily peeled off.

A problem to be solved by the invention is to provide a wiring body assembly, a wiring board, and a touch sensor which can suppress peeling of two wiring bodies.

### MEANS FOR SOLVING PROBLEM

[1] A wiring body assembly according to the invention is a wiring body assembly including: a first wiring body including a first insulating portion, a first lead wiring and a first terminal portion, the first lead wiring and the first terminal portion being formed on one surface of the first insulating portion; a second wiring body including a second insulating portion, a second lead wiring and a second terminal portion, the second lead wiring and the second terminal portion being formed on the other surface of the second insulating portion; and a conductive adhering portion connecting the first terminal portion and the second terminal portion, in which the first wiring body and the second wiring body overlap each other so that the first terminal portion and the second terminal portion face each other via the conductive adhering portion, the conductive adhering portion includes a first protruding portion protruding from a space between the first wiring body and the second wiring body, the first protruding portion covers a portion of an end surface of the first wiring body, and a portion of the end surface of the first wiring body includes at least a region overlapping the second wiring body in a stacking direction of the first wiring body and the second wiring body.
[2] In the above invention, the first protruding portion may cover a portion of an end surface of the first insulating portion, and a portion of the end surface of the first insulating portion may include at least a region overlapping the second wiring body in the stacking direction.
[3] In the above invention, the second wiring body may further include a cover portion including at least a cover layer formed on the other surface of the second insulating portion so as to cover the second lead wiring, and the cover layer may not overlap the first wiring body in the stacking direction.
[4] In the above invention, the conductive adhering portion may be in contact with at least a portion of the cover portion.
[5] In the above invention, the first protruding portion may be in contact with the cover portion.
[6] In the above invention, the first protruding portion may cover a portion of the other surface of the cover portion.
[7] In the above invention, the cover portion may include an adhesive layer interposed between the cover layer and the second lead wiring, the adhesive layer may include a second protruding portion protruding toward a distal end side of the second wiring body from a distal end of the cover layer, and the second protruding portion may overlap the first wiring body in the stacking direction.
[8] In the above invention, it is preferable that the second protruding portion does not overlap the first terminal portion in the stacking direction.
[9] In the above invention, the conductive adhering portion may be in contact with both the cover layer and the adhesive layer.
[10] In the above invention, the cover layer may overlap the first insulating portion in an extending direction of the second wiring body.
[11] In the above invention, the first terminal portion may extend to an edge portion of the first wiring body, and the first protruding portion may cover a portion of an end surface of the first terminal portion.
[12] In the above invention, a material of which the first insulating portion is made may include a resin material having optical isotropy.
[13] A wiring board according to the invention is a wiring board including the above-described wiring body assembly and a supporting body provided on one surface or the other surface of the first wiring body to support the first wiring body.
[14] A touch sensor according to the invention is a touch sensor including the wiring board.

### EFFECT OF THE INVENTION

According to the invention, it is possible to suppress peeling of the two wiring bodies.

### BRIEF DESCRIPTION OF DRAWINGS

Fig. 1 is a plan view illustrating a touch sensor according to an embodiment of the invention;
Fig. 2 is an exploded perspective view of the touch sensor;
Fig. 3 is an enlarged plan view illustrating a connection portion of a first wiring body and a second wiring body;
Fig. 4 is a perspective view of a second wiring body when viewed from a lower surface side thereof;
Fig. 5 is a cross-sectional view taken along line V-V of Fig. 3;
Fig. 6 is a cross-sectional view taken along line VI-VI of Fig. 3;
Fig. 7 is an enlarged plan view illustrating a connection portion of the first wiring body and the second wiring body in a state in which no sealing resin is formed;
Fig. 8 is a cross-sectional view illustrating a connecting method (1 thereof) of the first wiring body and the second wiring body;
Fig. 9 is a cross-sectional view illustrating a connecting method (2 thereof) of the first wiring body and the second wiring body;
Fig. 10 is an enlarged cross-sectional view illustrating a connection portion of a first wiring body and a second wiring body according to Comparative Example 1;
Fig. 11 is an enlarged cross-sectional view illustrating a connection portion of a first wiring body and a second wiring body according to Comparative Example 2; and
Fig. 12 is an enlarged cross-sectional view illustrating a connection portion of a first wiring body and a second wiring body according to another embodiment of the invention.

### MODE(S) FOR CARRYING OUT THE INVENTION

Hereinafter, embodiments of the invention will be described with reference to the drawings.

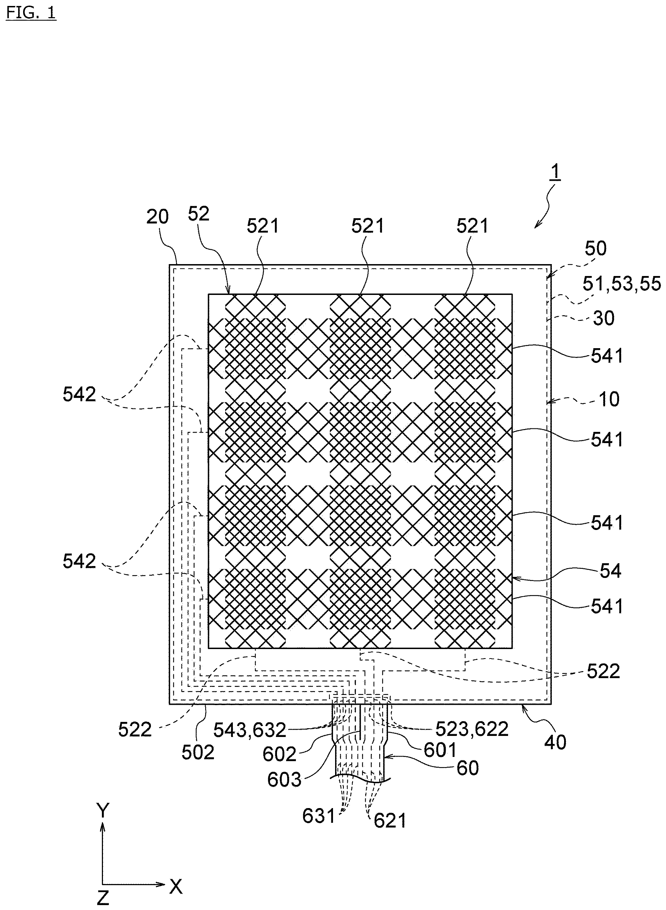

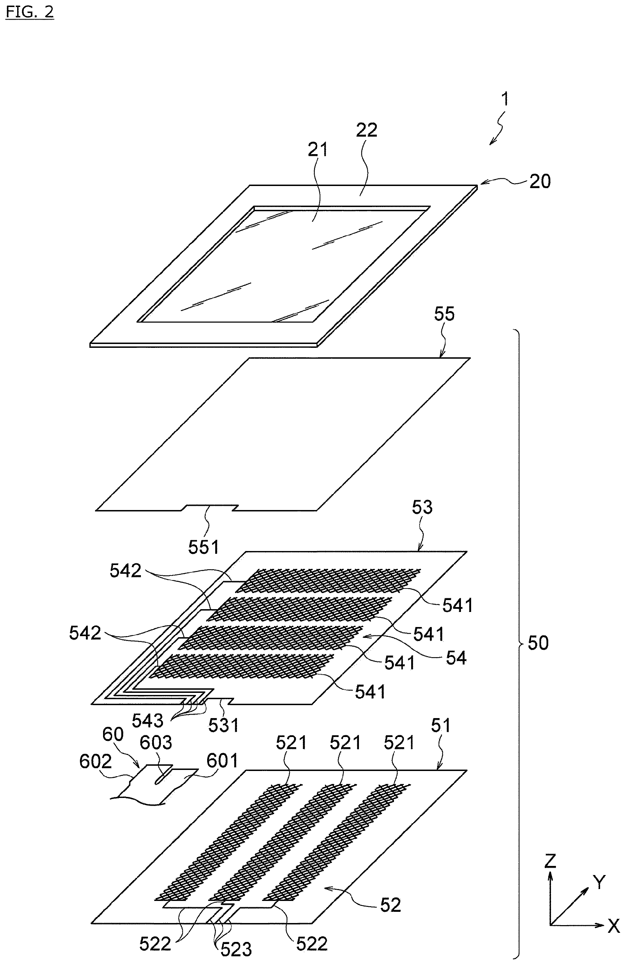

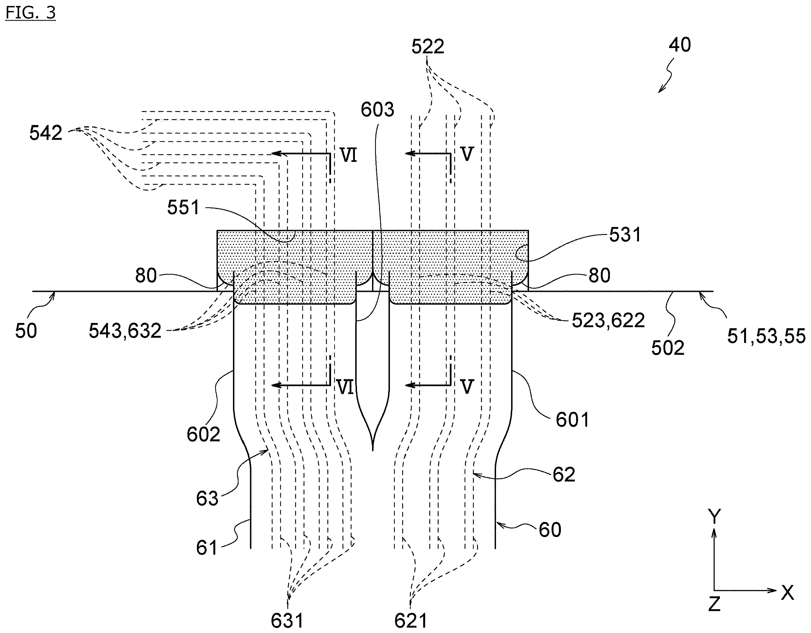

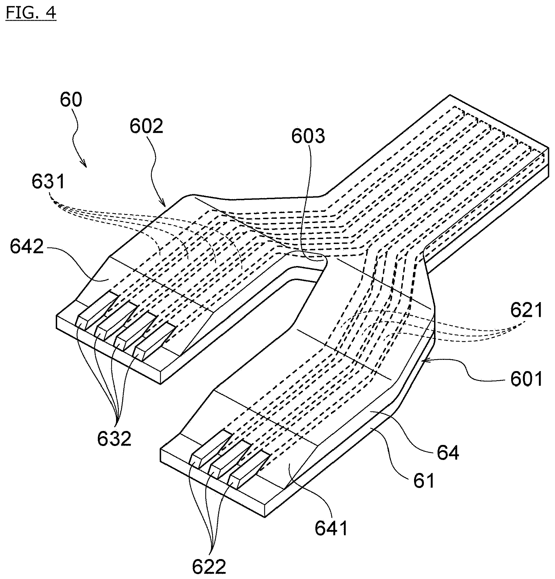

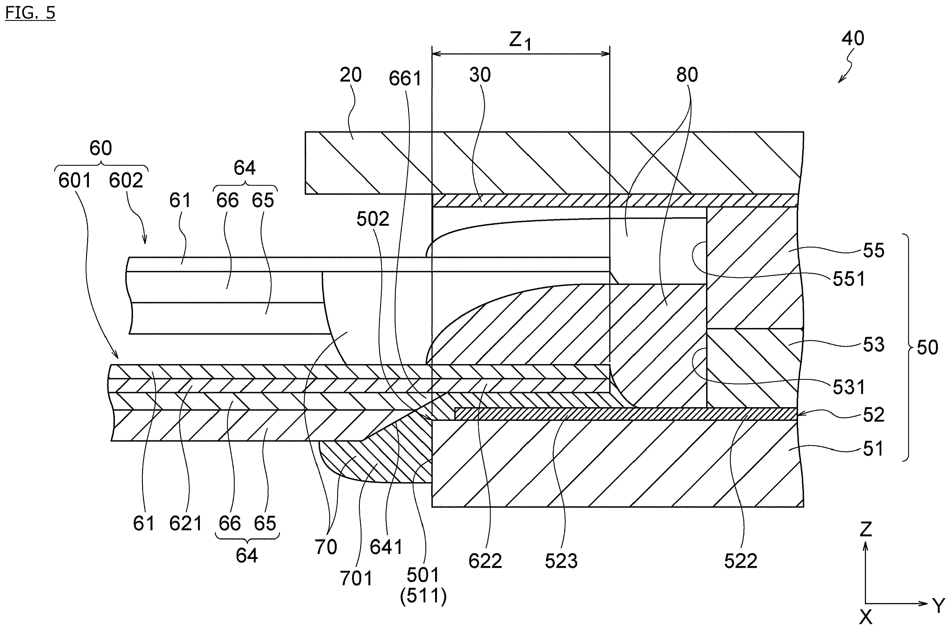

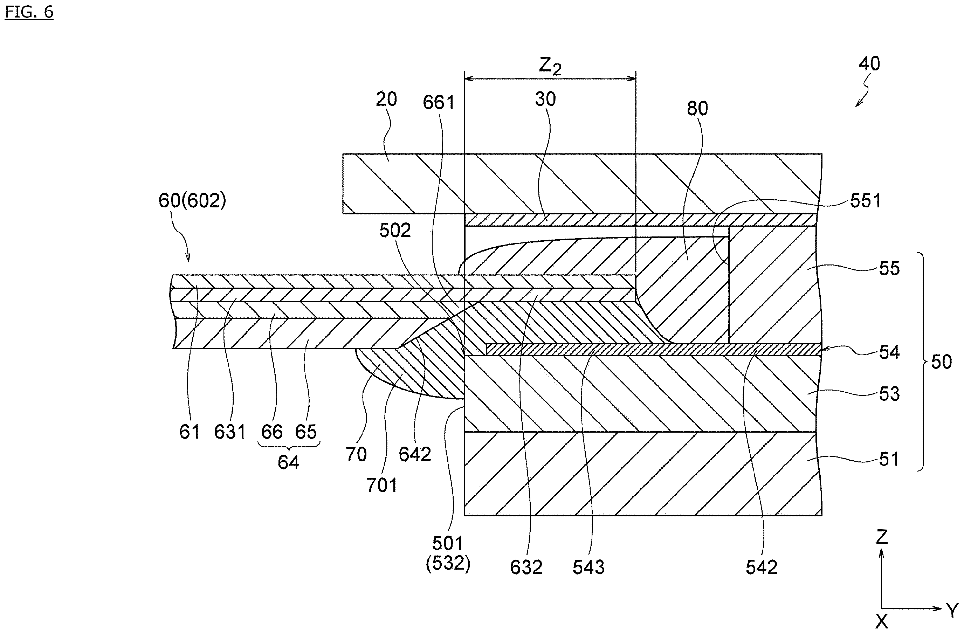

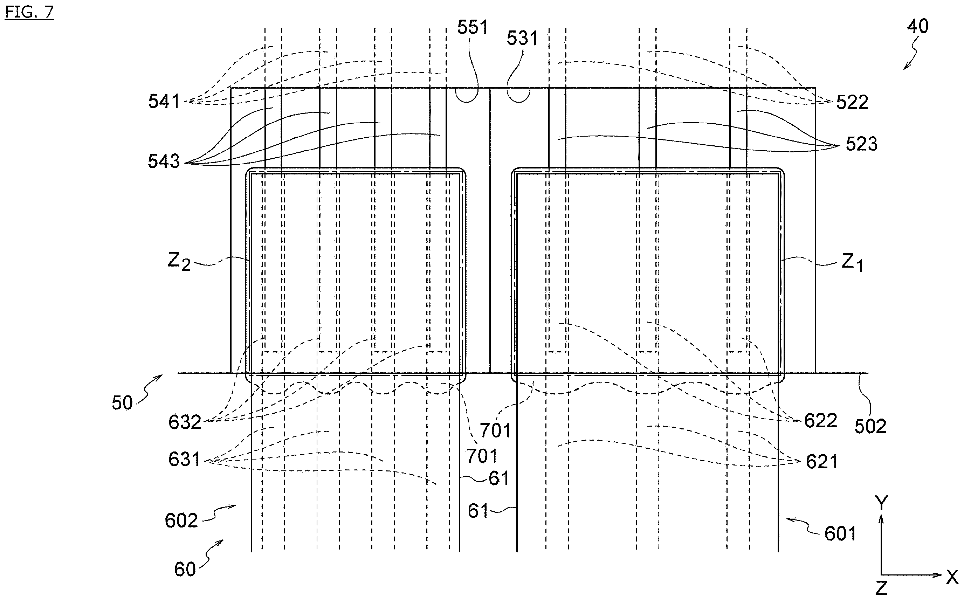

Fig. 1 is a perspective view illustrating a touch sensor according to an embodiment of the invention, Fig. 2 is an exploded perspective view of the touch sensor, Fig. 3 is an enlarged plane view of a connection portion of a first wiring body and a second wiring body, Fig. 4 is a perspective view of the second wiring body when viewed from the lower surface side thereof, Fig. 5 is a cross-sectional view taken along line V-V of Fig. 3, Fig. 6 is a cross-sectional view taken along line VI-VI of Fig. 3, and Fig. 7 is an enlarged plan view illustrating the connection portion of the first wiring body and the second wiring body in a state in which no sealing resin is formed.

The touch sensor 1 illustrated in Fig. 1 is a projection-type electrostatic-capacitive touch panel sensor and is used as an input device having a function of detecting a touch position in combination with, for example, a display device (not illustrated) or the like. The display device is not particularly limited, and a liquid crystal display, an organic EL display, electronic paper, or the like can be used. The touch sensor 1 has detection electrodes and driving electrodes (first and second electrode portions 521 and 541 described later) disposed to face each other, and a predetermined voltage is periodically applied between the two electrodes from an external circuit (not illustrated) via a wiring body 60.

In such a touch sensor 1, for example, when a finger (external conductor) of an operator approaches the touch sensor 1, a condenser (electrostatic capacitance) is formed between the external conductor and the touch sensor 1, and thus, the electrical state between the two electrodes changes. The touch sensor 1 can detect the operation position of the operator on the basis of an electrical change between the two electrodes.

As illustrated in Figs. 1 and 2, the touch sensor 1 includes a cover panel 20, a transparent adhesive layer 30, a wiring body assembly 40 provided on one surface of the cover panel 20 via a transparent adhesive layer 30.

The cover panel 20 has a rectangular shape and includes a transparent portion 21 capable of transmitting visible light and a shielding portion 22 shielding visible light. The transparent portion 21 is formed in a rectangular shape, and the shielding portion 22 is formed in a rectangular frame shape around the transparent portion 21. As a transparent material constituting the cover panel 20, for example, a glass material such as soda lime glass or borosilicate glass, and a resin material such as polymethyl methacrylate (PMMA) and polycarbonate (PC) can be exemplified. The shielding portion 22 is formed by, for example, applying black ink to an outer peripheral portion of the back surface of the cover panel 20. A first wiring body 50 (described later) of the wiring body assembly 40 is attached to the cover panel 20, and the first wiring body 50 is supported by the cover panel 20. In this case, it is preferable that the cover panel 20 has a rigidity enough to support the first wiring body 50.

The transparent adhesive layer 30 is interposed between the cover panel 20 and the wiring body assembly 40. The transparent adhesive layer 30 is an optical transparent adhesive film and can be formed by using a known adhesive such as a silicone resin based adhesive, an acrylic resin based adhesive, a urethane resin based adhesive, or a polyester resin based adhesive. Herein, in the embodiment, the transparent adhesive layer 30 is formed on the lower surface of the cover panel 20 in advance, but in a case where the layer on the cover panel 20 side of the wiring body assembly 40 is an adhesive layer, since the formation of the transparent adhesive layer 30 is unnecessary, the transparent adhesive layer 30 may be omitted.

As illustrated in Figs. 1 to 3, the wiring body assembly 40 includes a first wiring body 50, a second wiring body 60, a conductive adhering portion 70, and a sealing resin 80.

As illustrated in Fig. 2, the first wiring body 50 includes a first resin portion 51, a first conductor portion 52, a second resin portion 53, a second conductor portion 54, and a third resin portion 55. In order to ensure the visibility of the display device, the first wiring body 50 is configured so as to have transparency (translucency) as a whole.

The first resin portion 51 has a rectangular shape and is made of a resin material having transparency. As the resin material having transparency, for example, UV curable resins or thermosetting resins such as an epoxy resin, an acrylic resin, a urethane resin, a silicone resin, and a phenol resin can be exemplified.

In the embodiment, the first resin portion 51 is made of a material having optical isotropy. In this case, the retardation value Re of the material constituting the first resin portion 51 is 10 nm or less. In this specification, the phrase "having optical isotropy" denotes that the retardation value Re is 10 nm or less. The first resin portion 51 made of such a material having optical isotropy can be manufactured by a method not accompanied by, for example, a stretching process such as a casting method.

The first conductor portion 52 is provided on the upper surface (the surface of the main surfaces of the first resin portion 51 on the side facing the second wiring body 60) of the first resin portion 51, and is retained by the resin portion 51. The first conductor portion 52 includes a plurality of first electrode portions 521, a plurality of first lead wirings 522, and a plurality of first terminal portions 523. The first electrode portion 521 has a mesh shape. Each of the first electrode portions 521 extends in the Y direction in the figure, and the plurality of first electrode portions 521 are juxtaposed in the X direction in the figure. One end of the first lead wiring 522 is connected to one end of each of the first electrode portions 521 in the longitudinal direction. The first terminal portion 523 is connected to the other end of each of the first lead wirings 522. The first terminal portion 523 does not extend to an edge portion 502 of the first wiring body 50 and does not form an end surface 501 of the first wiring body 50.

The number of the first electrode portions 521 is not particularly limited and can be arbitrarily set. The number of the first lead wirings 522 and the number of the first terminal portions 523 are set according to the number of the first electrode portions 521.

The first conductor portion 52 is made of a conductive material (conductive particles) and a binder resin. As the conductive material, metal materials such as silver, copper, nickel, tin, bismuth, zinc, indium, or palladium or carbon-based materials such as graphite, carbon black (furnace black, acetylene black, or ketjen black), carbon nanotube or carbon nanofiber can be exemplified. As a conductive material, a metal salt may be used. As the metal salt, salts of the above-mentioned metals can be exemplified. As the binder resin, an acrylic resin, a polyester resin, an epoxy resin, a vinyl resin, a urethane resin, a phenol resin, a polyimide resin, a silicone resin, a fluororesin, and the like can be exemplified. Such a first conductor portion 52 is formed by applying a conductive paste and curing the resulting product. As a specific example of such a conductive paste, a conductive paste formed by mixing the above-described conductive material and a binder resin in water or a solvent and various additives can be exemplified. As the solvent contained in the conductive paste, α-terpineol, butyl carbitol acetate, butyl carbitol, 1-decanol, butyl cellosolve, diethylene glycol monoethyl ether acetate, tetradecane, and the like can be exemplified. The binder resin may be omitted from the material constituting the first conductor portion 52.

The second resin portion 53 has a rectangular shape and is made of a resin material having transparency. As the resin material having transparency, for example, the same material as the resin material constituting the above-mentioned first resin portion 51 can be used. In this case, it is preferable that the second resin portion 53 is made of a material having optical isotropy, and it is preferable that the material constituting the first resin portion 51 and the material constituting the second resin portion 53 have the same composition.

Herein, the configuration that the two resin materials have the same composition denotes the following case. That is, the configuration denotes that all of one or two or more unit structures constituting a main chain of one resin material are contained in a main chain of the other resin material, and all of one or two or more unit structures constituting the main chain of the other resin material are contained in the main chain of one resin material.

It is preferable that, in a case where two resin materials have the same composition, all of one or two or more substituents or functional groups constituting a side chain of one resin material are contained in a side chain of the other resin material, and all of one or two or more substituents or functional groups constituting the side chain of the other resin material are contained in the side chain of one resin material.

In a case where the two resin materials have the same composition, it is preferable that the average molecular weight of one resin material and the average molecular weight of the other resin material are substantially equal to each other.

In a case where the two resin materials have the same composition, it is preferable that the infrared absorption spectrum obtained by infrared spectroscopic analysis performed on one resin material and the infrared absorption spectrum obtained from infrared spectroscopic analysis performed on the other resin material are substantially equal to each other.

The second resin portion 53 is formed so as to cover the upper surface of the first resin portion 51, the first electrode portion 521, and the first lead wiring 522. Herein, a first notch portion 531 having a rectangular shape is formed on one side (specifically, one side located in the edge portion 502 of the first wiring body 50 intersecting the second wiring body 60) of the second resin portion 53. The first terminal portion 523 is exposed from the first notch portion 531, so that it is possible to connect the first terminal portion 523 and the third terminal portion 622 (described later) of the second wiring body 60 via the conductive adhering portion 70.

The second conductor portion 54 is provided on the upper surface of the second resin portion 53. The second conductor portion 54 includes a plurality of second electrode portions 541, a plurality of second lead wirings 542, and a plurality of second terminal portions 543. The second electrode portion 541 has a mesh shape. Each of the second electrode portions 541 extends in the X direction in the figure, and the plurality of second electrode portions 541 are juxtaposed in the Y direction in the figure. One end of the second lead wiring 542 is connected to one end of each second electrode portion 541 in the longitudinal direction. Each of the second lead wirings 542 extends from one end of each second electrode portion 541 in the longitudinal direction to a connection portion with the second wiring body 60, and the second terminal portion 543 is connected to the other end of each of the second lead wirings 542. The second terminal portion 543 does not extend to the edge portion 502 of the first wiring body 50 and does not form the end surface 501 of the first wiring body 50.

The number of the second electrode portions 541 is not particularly limited and can be arbitrarily set. The number of the second lead wirings 542 and the number of the second terminal portions 543 are set according to the number of the second electrode portions 541.

Similarly to the first conductor portion 52, the second conductor portion 54 is made of a conductive material (conductive particles) and a binder resin. Like the first conductor portion 52, such a second conductor portion 54 is also formed by applying and curing a conductive paste.

The third resin portion 55 has a rectangular shape and is made of a resin material having transparency. As the resin material having transparency, for example, the same material as the above-mentioned resin material constituting the first resin portion 51 can be used. In this case, it is preferable that the third resin portion 55 is made of a material having optical isotropy, and the material constituting the first resin portion 51 and the material constituting the third resin portion 55 have the same composition.

The third resin portion 55 is formed so as to cover the upper surface of the second resin portion 53, the second electrode portion 541, and the second lead wiring 542. Herein, a second notch portion 551 having a rectangular shape is formed on one side (specifically, one side located in the edge portion 502 of the first wiring body 50 intersecting the second wiring body 60) of the third resin portion 55. The second terminal portion 543 is exposed from the second notch portion 551, so that it is possible to contact the second terminal portion 543 and a fourth terminal portion 632 (described later) of the second wiring body 60 via the conductive adhering portion 70. In addition, the second notch portion 551 overlaps the first notch portion 531, and the first terminal portion 523 is also exposed from the second notch portion 551.

The second wiring body 60 is a flexible printed circuit (FPC). In the embodiment, as illustrated in Figs. 3 and 4, a slit 603 is formed at the width-direction center of one end of the second wiring body 60 in the longitudinal direction, and the one end of the second wiring body 60 in the longitudinal direction is divided into two portions in the width direction by the slit 603. One side (first branch portion 601) of one end of the second wiring body 60 in the longitudinal direction corresponds to the first terminal portion 523. On the other hand, the other side (the second branch portion 602) of one end of the second wiring body 60 in the longitudinal direction corresponds to the second terminal portion 543.

The second wiring body 60 includes a band-shaped substrate 61, third and fourth conductor portions 62 and 63 formed on the lower surface (the surface of the main surfaces of the substrate 61 on the side facing the first wiring body 60) of the substrate 61, and a cover portion 64 covering portions of the third and fourth conductor portions 62 and 63.

The substrate 61 can be configured with a film material made of, for example, polyethylene terephthalate (PET), polyethylene naphthalate (PEN), a polyimide resin (PI),a polyetherimide resin (PEI), or the like.

The third conductor portion 62 is formed on the lower surface of the first branch portion 601 and includes a plurality of third lead wirings 621 and a plurality of third terminal portions 622. The third lead wiring 621 extends along the first branch portion 601. One end of the third lead wiring 621 in the longitudinal direction is connected to the third terminal portion 622. The third terminal portion 622 is disposed in the vicinity of the distal end of the first branch portion 601. Each of the plurality of third terminal portions 622 respectively faces each of the plurality of first terminal portions 523.

The fourth conductor portion 63 is formed on the lower surface of the second branch portion 602 and includes a plurality of fourth lead wirings 631 and a plurality of fourth terminal portions 632. The fourth lead wiring 631 extends along the second branch portion 602. One end of the fourth lead wiring 631 in the longitudinal direction is connected to the fourth terminal portion 632. The fourth terminal portion 632 is disposed in the vicinity of the distal end of the second branch portion 602. Each of the plurality of fourth terminal portions 632 respectively faces each of the plurality of second terminal portions 543.

The cover portion 64 is provided on the lower surface of the substrate 61. The cover portion 64 includes a cover layer 65 and an adhesive layer 66. The cover layer 65 can be configured with a film material made of, for example, polyethylene terephthalate (PET), polyethylene naphthalate (PEN), a polyimide resin (PI), a polyetherimide resin (PEI) or the like. The adhesive layer 66 can be formed by using a known adhesive such as an epoxy resin based adhesive, a silicone resin based adhesive, an acrylic resin based adhesive, a urethane resin based adhesive, a polyester resin based adhesive, or the like.

The cover layer 65 is formed on the lower surface of the substrate 61 so as to cover the third lead wiring 621 and the fourth lead wiring 631. The adhesive layer 66 is interposed between the cover layer 65 and the third lead wiring 621 and between the cover layer 65 and the fourth lead wiring 631. The adhesive layer 66 retains the cover layer 65 on the substrate 61, the third lead wiring 621, and the fourth lead wiring 631. A third notch portion 641 in which the cover portion 64 is not formed is formed in the vicinity of the distal end of the first branch portion 601. The third terminal portion 622 is exposed from the third notch portion 641.

The third notch portion 641 in which the cover portion 64 is not formed is formed in the vicinity of the distal end of the first branch portion 601. The third terminal portion 622 is exposed from the third notch portion 641. In this case, the cover layer 65 does not overlap the first wiring body 50 in the stacking direction of the first wiring body 50 and the second wiring body 60 (that is, in a case where the cover layer 65 is projected in the stacking direction, the cover layer 65 and the first wiring body 50 do not overlap each other).

In the first branch portion 601, one end (the portion of the cover layer 65 forming the third notch portion 641) of the cover layer 65 in the longitudinal direction gradually becomes thinner as approaching to the distal end of the first branch portion 601. One end (the portion of the adhesive layer 66 forming the third notch portion 641) of the adhesive layer 66 in the longitudinal direction also gradually becomes thinner as approaching the distal end of the first branch portion 601. Accordingly, an inclined surface inclined so as to approach the substrate 61 as approaching the distal end of the first branch portion 601 is formed at one end of the cover portion 64 in the longitudinal direction.

A second protruding portion 661 that protrudes toward the distal end side of the first branch portion 601 from one end of the cover layer 65 in the longitudinal direction is formed at one end of the adhesive layer 66 in the longitudinal direction. The second protruding portion 661 does not overlap the cover layer 65 in the stacking direction (hereinafter, also referred to simply as the stacking direction) of the first wiring body 50 and the second wiring body 60 (that is, in a case where the second protruding portion 661 is projected in the stacking direction, the second protruding portion 661 and the cover layer 65 do not overlap each other). Although not particularly limited, it is preferable that the length of the second protruding portion 661 along the extending direction of the first branch portion 601 is 50 µm to 100 µm.

In the embodiment, in the first branch portion 601, the cover layer 65 does not overlap the first wiring body 50 in the stacking direction. On the other hand, a portion of the second protruding portion 661 of the adhesive layer 66 overlaps the first wiring body 50 in the stacking direction. In the embodiment, since the first terminal portion 523 does not extend to the edge portion 502 of the first wiring body 50, the second protruding portion 661 overlaps the first resin portion 51 but does not overlap the first terminal portion 523 in the stacking direction.

In the first branch portion 601, at least a portion of the cover layer 65 overlaps the first resin portion 51 in the extending direction of the first branch portion 601 (that is, in a case where the cover layer 65 is projected in the extending direction of the first branch portion 601, the cover layer 65 and the first resin portion 51 overlap each other). The cover layer 65 and the first wiring body 50 are not in direct contact with each other but separated from each other.

As illustrated in Fig. 6, similarly to the first branch portion 601, in the second branch portion 602, the cover layer 65 is formed on the lower surface of the substrate 61 so as to cover the fourth lead wiring 631. The adhesive layer 66 is interposed between the cover layer 65 and the fourth lead wiring 631, and the adhesive layer 66 retains the cover layer 65 on the substrate 61 and the fourth lead wiring 631. A fourth notch portion 642 in which the cover portion 64 is not formed is formed in the vicinity of the distal end of the second branch portion 602. The fourth terminal portion 632 is exposed from the fourth notch portion 642.

The fourth notch portion 642 in which the cover portion 64 is not formed is formed in the vicinity of the distal end of the second branch portion 602. The fourth terminal portion 632 is exposed from the fourth notch portion 642.

In the second branch portion 602, one end (the portion of the cover layer 65 forming the fourth notch portion 642) of the cover layer 65 in the longitudinal direction gradually becomes thinner as approaching the distal end of the second branch portion 602. One end (the portion of the adhesive layer 66 forming the fourth notch portion 642) of the adhesive layer 66 in the longitudinal direction also gradually becomes thinner as approaching the distal end of the second branch portion 602. Accordingly, an inclined surface inclined so as to approach the substrate 61 as approaching the distal end of the second branch portion 602 is formed at one end of the cover portion 64 in the longitudinal direction.

A second protruding portion 661 protruding toward the distal end side of the second branch portion 602 from one end of the cover layer 65 in the longitudinal direction is formed at one end of the adhesive layer 66 in the longitudinal direction. The second protruding portion 661 does not overlap the cover layer 65 in the stacking direction (that is, in a case where the second protruding portion 661 is projected in the stacking direction, the second protruding portion 661 and the cover layer 65 do not overlap each other).

In the second branch portion 602, the cover layer 65 does not overlap the first wiring body 50 in the stacking direction. On the other hand, the second protruding portion 661 of the adhesive layer 66 overlaps the first wiring body 50 in the stacking direction. In the embodiment, since the second terminal portion 543 does not extend to the edge portion 502 of the first wiring body 50, the second protruding portion 661 overlaps the resin portion 53 of the first wiring body 50 in the stacking direction but does not overlap the second terminal portion 543.

In the second branch portion 602, at least a portion of the cover layer 65 overlaps the second resin portion 53 in the extending direction of the second branch portion 602 (that is, in a case where the cover layer 65 is projected in the extending direction of the second branch portion 602, the cover layer 65 and the second resin portion 53 overlap each other). The cover layer 65 and the first wiring body 50 are not in direct contact with each other but are separated from each other.

As illustrated in Fig. 5, the conductive adhering portion 70 is interposed between the first wiring body 50 and the first branch portion 601, and the conductive adhering portion 70 electrically and mechanically connects the first terminal portion 523 and the third terminal portion 622. As illustrated in Fig. 6, the conductive adhering portion 70 is interposed between the first wiring body 50 and the second branch portion 602, and the conductive adhering portion 70 electrically and mechanically connects the second terminal portion 543 and the fourth terminal portion 632.

As the conductive adhering portion 70, an anisotropic conductive film (ACF) or an anisotropic conductive paste (ACP) can be used.

As illustrated in Fig. 5, such a conductive adhering portion 70 is interposed between the first wiring body 50 and the first branch portion 601. In the embodiment, as illustrated in Figs. 5 and 7, the conductive adhering portion 70 includes a first protruding portion 701 protruding from a space (a region (hereinafter, also referred to as a first connection region Z₁) overlapping the first wiring body 50 and the first branch portion 601) between the first wiring body 50 and the first branch portion 601.

The first protruding portion 701 is formed along the periphery of the first connection region Z₁ and protrudes from the edge portion 502 of the first wiring body 50. The first protruding portion 701 is formed to be thicker than the conductive adhering portion 70 existing in the first connection region Z₁, and the first protruding portion 701 covers a portion of the end surface 501 of the first wiring body 50 and covers a portion of the lower surface of the first branch portion 601. The portion of the end surface 501 of the first wiring body 50 includes at least a region overlapping the first branch portion 601 in the stacking direction.

In particular, in the embodiment, the first protruding portion 701 covers a portion of the end surface 511 of the first resin portion 51 in the end surface 501. A portion of the end surface 511 of the first resin portion 51 includes at least a region overlapping the first branch portion 601 in the stacking direction. The first protruding portion 701 is in contact with the cover portion 64 (specifically, both the cover layer 65 and the adhesive layer 66). The first protruding portion 701 spreads so as to cover a portion of the lower surface (the surface opposite to the side in contact with the third lead wiring 621) of the cover portion 64.

As illustrated in Fig. 7, the protrusion amount (hereinafter, also simply referred to as the protrusion amount of the first protruding portion 701) of the first protruding portion 701 along the extending direction of the first branch portion 601 is not uniform in the direction along the edge portion 502. Specifically, the protrusion amount of the first protruding portion 701 in a portion overlapping the third terminal portion 622 as viewed in a plane is larger than the protrusion amount of the first protruding portion 701 in a portion not overlapping the third terminal portion 622 as viewed in a plane.

As illustrated in Fig. 6, the conductive adhering portion 70 is also interposed between the first wiring body 50 and the second branch portion 602. As illustrated in Figs. 6 and 7, the conductive adhering portion 70 includes the first protruding portion 701 protruding from a space (a region (hereinafter, also referred to as a second connection region Z₂) overlapping the first wiring body 50 and the second branch portion 602) between the first wiring body 50 and the second branch portion 602.

The first protruding portion 701 is formed along the periphery of the second connection region Z₂ and protrudes from the edge portion 502 of the first wiring body 50. The first protruding portion 701 is formed to be thicker than the conductive adhering portion 70 existing in the second connection region Z₂, and the first protruding portion 701 covers a portion of the end surface 501 of the first wiring body 50 and covers a portion of the lower surface of the second branch portion 602. The portion of the end surface 501 of the first wiring body 50 includes at least a region overlapping the second branch portion 602 in the stacking direction.

In particular, in the embodiment, the first protruding portion 701 covers a portion of the end surface 532 of the second resin portion 53 in the end surface 501. A portion of the end surface 532 of the second resin portion 53 includes at least a region overlapping the second branch portion 602 in the stacking direction. The first protruding portion 701 is in contact with the cover portion 64 (specifically, both the cover layer 65 and the adhesive layer 66). The first protruding portion 701 spreads so as to cover a portion of the lower surface (the surface opposite to the side in contact with the fourth lead wiring 631) of the cover portion 64.

As illustrated in Fig. 7, the protrusion amount (hereinafter, also simply referred to as the protrusion amount of the first protruding portion 701) of the first protruding portion 701 along the extending direction of the second branch portion 602 is not uniform in the direction along the edge portion 502. Specifically, the protrusion amount of the first protruding portion 701 in the portion overlapping the fourth terminal portion 632 as viewed in a plane is larger than the protrusion amount of the first protruding portion 701 in the portion not overlapping the fourth terminal portion 632 as viewed in a plane.

As illustrated in Fig. 5, the sealing resin 80 is provided so as to collectively cover the interior of the first notch portion 531 and the vicinity of the distal end of the first branch portion 601. As illustrated in Fig. 6, the sealing resin 80 is provided so as to collectively cover the interior of the second notch portion 551 and the vicinity of the distal end of the second branch portion 602. The sealing resin 80 covers the first terminal portion 523 exposed from the first notch portion 531 and the second terminal portion 543 exposed from the second notch portion 551, so that the first terminal portion 523 and the second terminal portion 543 are hard to be in contact with the side air. Since the sealing resin 80 covers the vicinities of the distal ends of the first branch portion 601 and the second branch portion 602, the reliability of the connection strength between the first wiring body 50 and the second wiring body 60 is improved.

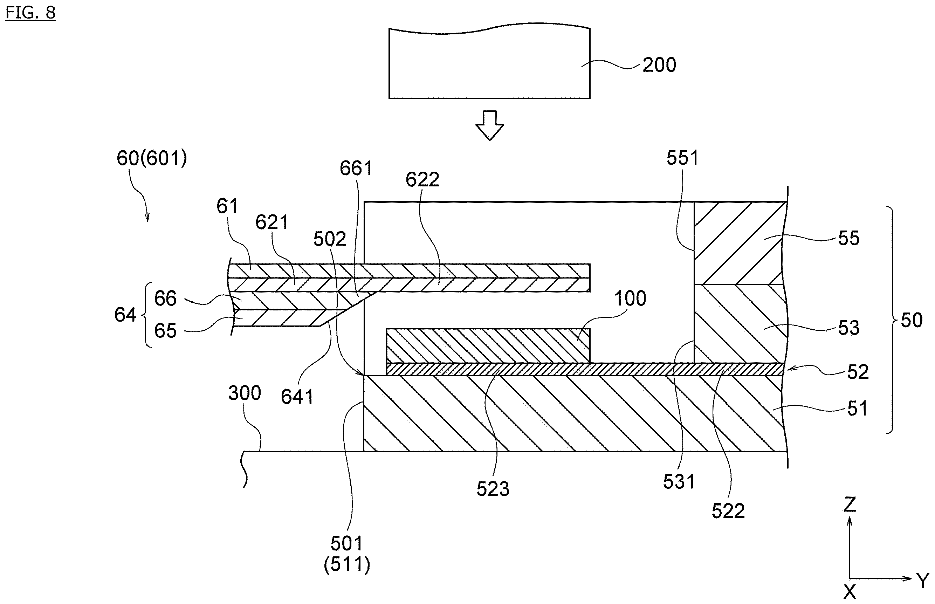

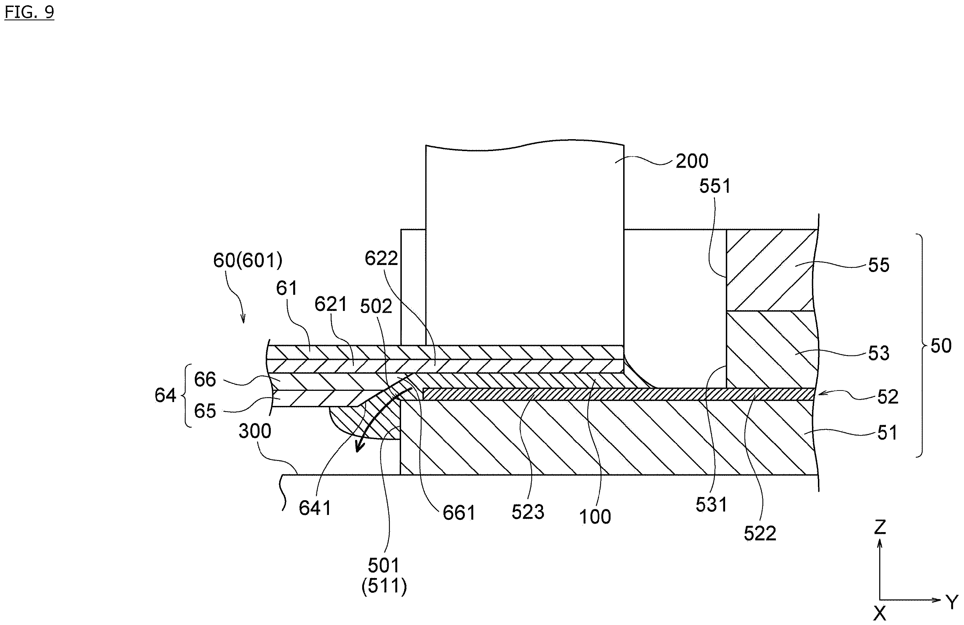

Next, a connecting method of the first wiring body 50 and the second wiring body 60 will be described with reference to Figs. 8 and 9. Figs. 8 and 9 are cross-sectional views illustrating a connecting method of the first wiring body and the second wiring body. In connecting the first wiring body 50 and the second wiring body 60, since the connecting method of the first wiring body 50 and the first branch portion 601 is the same as the connecting method of the first wiring body 50 and the second branch portion 602, the description on the latter connecting method will be omitted, and the description on the former connecting method will be used.

First, the first wiring body 50 and the second wiring body 60 are prepared. Next, a conductive adhesive material 100 configured with ACF, ACP, or the like forming the conductive adhering portion 70 is disposed in the bonding region of the first wiring body 50. Specifically, the conductive adhesive material 100 is disposed in the first notch portion 531 of the first wiring body 50.

Next, as illustrated in Fig. 8, the vicinity of the distal end of the first branch portion 601 and the first wiring body 50 are thermocompression-adhered in a state of the conductive adhesive material 100 interposed therebetween by the crimp head 200 and the crimp stage 300. As a result, as illustrated in Fig. 9, the conductive adhesive material 100 protrudes from the space between the first wiring body 50 and the first branch portion 601, and thus, the conductive adhesive material 100 protrudes from the edge portion 502 of the first wiring body 50. The conductive adhesive material 100 protruding from the space between the first wiring body 50 and the first branch portion 601 spreads along the lower surface of the first branch portion 601 and comes into contact with the cover portion 64. Then, the cover portion 64 acts as a flow resistance of the conductive adhesive material 100, and the conductive adhesive material 100 rises along the end surface 501 of the first wiring body 50. In this case, since one end of the cover portion 64 in the longitudinal direction is formed to an inclined surface which is inclined so as to approach the substrate 61 as approaching the distal end of the first branch portion 601, the conductive adhesive material 100 easily protrudes from the space between the first wiring body 50 and the first branch portion 601, and, the conductive adhesive material 100 easily rise along the end surface 501 of the first wiring body 50.

In this case, the first branch portion 601 is disposed on the first wiring body 50 so that a portion of the second protruding portion 661 of the adhesive layer 66 overlaps the first wiring body 60 (specifically, the first resin portion 51) in the stacking direction.

When the first wiring body 50 and the first branch portion 601 are thermocompression-adhered, a portion of the conductive adhesive material 100 protrudes from the edge portion 502 of the first wiring body 50 so as to protrude between the first branch portion 601 and the first wiring body 50. Then, a portion of the protruding conductive adhesive material 100 comes into contact with both the cover layer 65 and the adhesive layer 66 of the cover portion 64.

Next, a sealing resin 80 is formed. Although not particular illustrated, in this process, a liquid resin material is dropped into the first notch portion 531 and the second notch portion 551 by using a dispenser, and the dropped resin material is cured by a known method. Accordingly, the first wiring body 50 and the second wiring body 60 can be connected. Through the above processes, the wiring body assembly 40 is obtained.

The wiring body assembly 40 of the embodiment has the following effects.

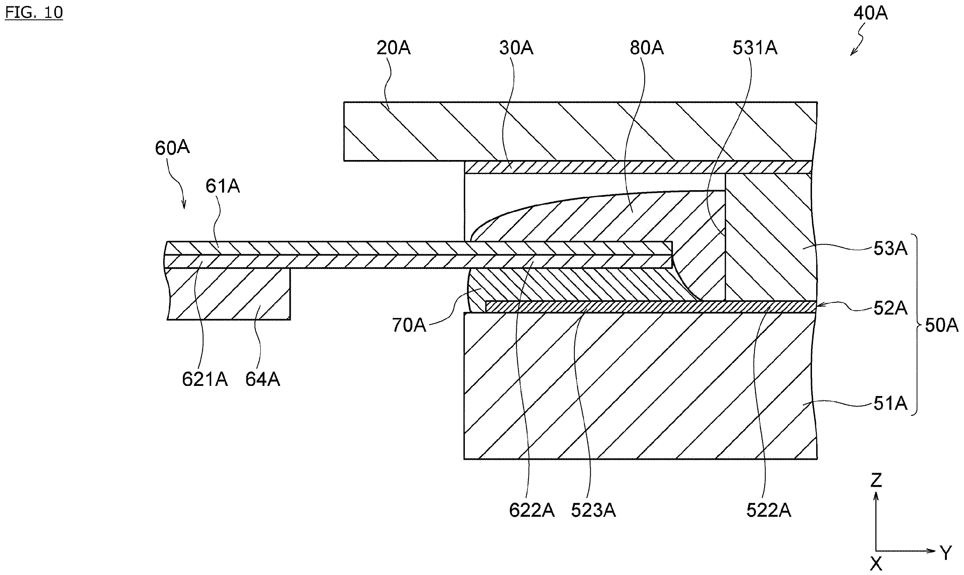

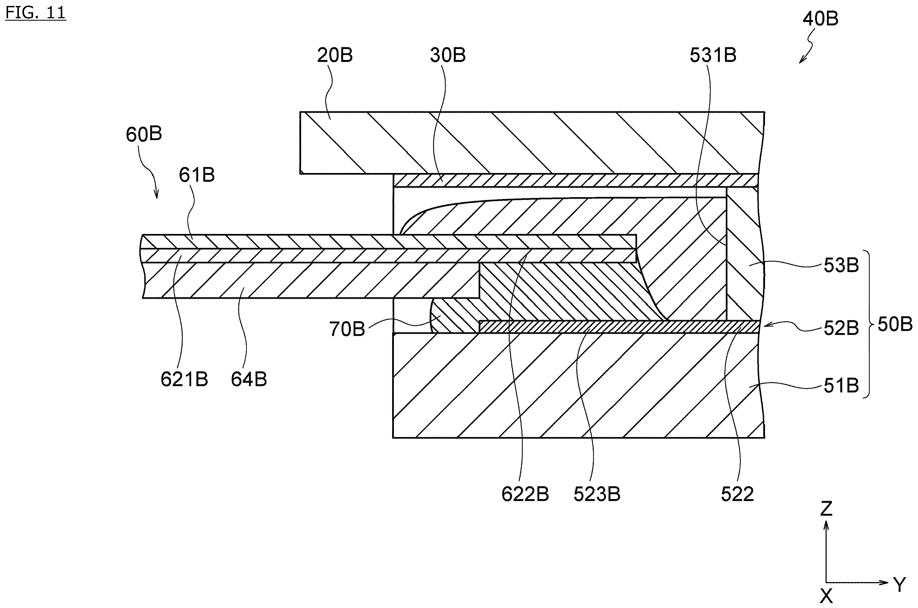

In the related art of a wiring body assembly in which two wiring bodies are connected by a conductive adhering portion, in order to suppress the usage amount of the conductive adhering portion to reduce the production cost, the conductive adhering portion is formed on only the region in which two wiring bodies overlap each other. Fig. 10 is an enlarged cross-sectional view illustrating a connection portion of the first wiring body 50A and a second wiring body 60A according to Comparative Example 1. Fig. 11 is an enlarged cross-sectional view illustrating a connection portion of a first wiring body 50B and a second wiring body 60B according to Comparative Example 2. For example, in a wiring body assembly 40A according to Comparative Example 1 illustrated in Fig. 10, a terminal portion 523A of the first wiring body 50A and a terminal portion 622A of the second wiring body 60A are connected by a conductive adhering portion 70A, but the first protruding portion 701 is not formed. In a wiring body assembly 40B according to Comparative Example 2 illustrated in Fig. 11, a terminal portion 523B of the first wiring body 50B and a terminal portion 622B of the second wiring body 60B are connected by a conductive adhering portion 70B, but the first protruding portion 701 is not formed. In the wiring body assemblies 40A and 40B as illustrated in Figs. 10 and 11, there was a concern that the wiring bodies are peeled off starting from the periphery of a region where the two wiring bodies overlap each other and where the stress concentration is likely to occur. In particular, in a case where the periphery of the overlapping region of the two wiring bodies and the edge portions of the wiring bodies overlap each other, the stress concentrate is more likely to occur, and the possibility that the two wiring bodies are peeled off is increased.

On the contrary, in the embodiment, the conductive adhering portion 70 includes the first protruding portion 701 protruding from the space between the first wiring body 50 and the second wiring body 60, and the first protruding portion 701 covers at least the region of the end surface 501 of the first wiring body 50, which overlaps the second wiring body 60 (the first branch portion 601 or the second branch portion 602) in the stacking direction. Accordingly, since the first wiring body 50 and the second wiring body 60 can be strongly bonded by the first protruding portion 701, it is possible to suppress the peeling of the first wiring body 50 and the second wiring body 60. In the embodiment, since the space between the first wiring body 50 and the second wiring body 60 is reliably filled with the conductive adhering portion 70, no gap is formed between the first wiring body 50 and the second wiring body 60. For this reason, it is possible to further suppress the peeling of the first wiring body 50 and the second wiring body 60.

In the embodiment, since the first protruding portion 701 covers at least a portion of the end surface 511 of the first resin portion 51, which overlaps the second wiring body 60 (the first branch portion 601 or the second branch portion 602) in the stacking direction, the first wiring body 50 and the first protruding portion 701 can be more firmly bonded to each other.

In the embodiment, since the cover layer 65 of the second wiring body 60 does not overlap the first wiring body 50 in the stacking direction of the first wiring body 50 and the second wiring body 60, the cover layer 65 does not overlap the first wiring body 50 in the stacking direction, so that it is possible to make it difficult for the stress concentration to occur on the connection portion of the first wiring body 50 and the second wiring body 60. In addition, it is possible for the conductive adhesive material 100 to easily protrude from the edge portion 502 of the first wiring body 50. Accordingly, it is possible to more reliably form the first protruding portion 701 on the end surface 501 of the first wiring body 50.

In the embodiment, since the first protruding portion 701 is in contact with the cover portion 64, it is possible to prevent the third conductor portion 62 and the fourth conductor portion 63 of the second wiring body 60 from being exposed to the outside of the wiring body 60. Accordingly, it is possible to prevent the third conductor portion 62 and the fourth conductor portion 63 from being deteriorated by being exposed to the outside air. In addition, since the second wiring body 60 is reinforced by the first protruding portion 701 of the conductive adhering portion 70, it is possible to suppress the breakage of the second wiring body 60. Furthermore, since the first protruding portion 701 covers a portion of the lower surface of the cover portion 64, it is possible to more firmly connect the first wiring body 50 and the second wiring body 60.

The edge portion of the cover portion 64A in Fig. 10 is separated from the first wiring body and is not in contact with the conductive adhering portion 70A. In the wiring body assembly 40A, a portion which is not covered with the cover portion 64A and the conductive adhering portion 70A exists in the conductor portion (the lead wirings 621A and the terminal portion 622A) of the second wiring body 60A. For this reason, in the second wiring body 60A, the portion not covered with the cover portion 64A and the conductive adhering portion 70A is thinned, and thus, the stress concentration is likely to occur. Accordingly, there is a concern that the thin portion is likely to be broken due to an external force or the like. In the thin portion, since the conductor portion is not covered with the cover portion 64A and the conductive adhering portion 70A, there is a concern that the conductor portion is exposed to the outside air to be deteriorated.

The second wiring body 60B in Fig. 11 has a cover portion 64B formed on the lower surface of the substrate 61B so as to cover the lead wiring 621B. The edge portion of the cover portion 64B overlaps the first wiring body 50B in the stacking direction of the first wiring body 50B and the second wiring body 60B. In the wiring body assembly 40B, the total thickness of the second wiring body 60B changes at the edge portion of the cover portion 64B as a boundary, and thus, the stress concentration is likely to occur on the portion where such thickness changes. In addition, there is a tendency that the stress concentration is likely to occur on the connection portion of the first wiring body 50B and the second wiring body 60B. Similarly to the wiring body assembly 40B, the portion where the thickness of the second wiring body 60B changes is disposed in the connection portion of the first wiring body 50B and the second wiring body 60B, so that there is a concern that the stress further concentrates on the connection portion, and the connection portion is likely to be broken. Particularly, in recent years, there is a tendency that the rigidity of the resin portion 51B is lowered due to the demand for reducing the thickness of the first wiring body 50B, and thus, if the stress concentration occurs on the connection portion of the first wiring body 50B and the second wiring body 60B, the possibility that the resin portion 51B is broken is increased. Furthermore, in a case where the rigidity of the cover portion 64B is larger than the rigidity of the resin portion 51B, there is a concern that the resin portion 51B may be preferentially broken.

In contrast to Comparative Example, in the embodiment, the cover layer 65 does not overlap the first wiring body 50 in the stacking direction, and the conductive adhering portion 70 is in contact with at least a portion of the cover portion 64. For this reason, since a portion which is not covered with either the cover portion 64 or the conductive adhering portion 70 does not exist in the connection portion of the first wiring body 50 and the second wiring body 60, it is possible to suppress the stress concentration on the connection portion. Since the cover layer 65 does not overlap the first wiring body 50 in the stacking direction, it is possible to make it difficult for the stress concentration to occur on the connection portion of the first wiring body 50 and the second wiring body 60. Since a portion which is not covered with either the cover portion 64 and the conductive adhering portion 70 does not exist in the second wiring body 60, it is unnecessary to perform a sealing process with a sealing resin or the like on the exposed portion of the third conductor portion 62 and the forth conductor portion 63 of the second wiring body 60, and thus, it is possible to simplify the manufacturing process.

In the embodiment, the cover portion 64 includes the adhesive layer 66 including the second protruding portion 661 protruding toward the distal end side of the second wiring body 60 from the distal end of the cover layer 65. Then, the second protruding portion 661 overlaps the first wiring body 50 in the stacking direction. In this manner, the connection portion of the first wiring body 50 and the second wiring body 60, on which the stress concentration is likely to occur, can be reinforced by the adhesive layer 66, so that it is possible to prevent the connection portion from being broken.

In the embodiment, the conductive adhering portion 70 is in contact with both the cover layer 65 and the adhesive layer 66 of the cover portion 64. For this reason, since the conductive adhering portion 70 is strongly bonded to the cover portion 64, it is possible to further suppress the breakage of the connection portion of the first wiring body 50 and the second wiring body 60.

In the embodiment, concerning the first branch portion 601, the cover layer 65 overlaps the first resin portion 51 in the extending direction of the second wiring body 60. For this reason, it is possible to reduce the overall thickness of the wiring body assembly 40. Similarly, concerning the second branch portion 602, the cover layer 65 overlaps the second resin portion 53 in the extending direction of the second wiring body 60. For this reason, it is possible to reduce the overall thickness of the wiring body assembly 40.

In the embodiment, the material constituting the first resin portion 51 of the first wiring body 50 has optical isotropy. The first resin portion 51 formed by using such a material has a lower rigidity than a PET substrate or a glass substrate in the related art. For this reason, as compared with a PET substrate or a glass substrate in the related art, the first resin portion 51 made of a material having optical isotropy is likely to have a lower durability, and the possibility that cracks or breakage occurs due to an external force is high. Even in such a case, in the embodiment, since the stress is prevented from concentrating on the connection portion of the first wiring body 50 and the second wiring body 60, it is possible to more reliably suppress crack generation in the first resin portion 51 and breakage of the first resin portion 51.

The "touch sensor 1" in the embodiment corresponds to an example of "touch sensor" in the invention, the "wiring board 10" in the embodiment corresponds to an example of the "wiring board" in the invention, the "cover panel 20" in the embodiment corresponds to an example of the "supporting body" in the invention, the "wiring body assembly 40" in the embodiment corresponds to an example of the "wiring body assembly" in the invention, the "first wiring body 50" in the embodiment corresponds to an example of the "first wiring body "in the invention, the "second wiring body 60" in the embodiment corresponds to an example of the "second wiring body" in the invention, the "conductive adhering portion 70" in the embodiment corresponds to an example of the "conductive adhering portion" in the invention, and the "first protruding portion 701" in the embodiment corresponds to an example of the "first protruding portion" in the invention.

In a case where the "first resin portion 51" in the embodiment is an example of the "first insulating portion" in the invention, the "first lead wiring 522" in the embodiment corresponds to an example of the "first lead wiring" in the embodiment, the "first terminal portion 523" in the embodiment corresponds to an example of the "first terminal portion" of the invention, the "substrate 61" in the embodiment corresponds to an example of the "second insulating portion" in the invention, the "third lead wiring 621" in the embodiment corresponds to an example of the "second lead wiring " in the invention, and the "third terminal portion 622" in the embodiment corresponds to an example of the "second terminal portion" in the invention.

In a case where the "second resin portion 53" in the embodiment is an example of the "first insulating portion" in the invention, the "second lead wiring 542" in the embodiment corresponds to an example of the "first lead wiring" in the invention, the "second terminal portion 543" in the embodiment corresponds to an example of the "first terminal portion" in the invention, the "substrate 61" in the embodiment corresponds to an example of the "second insulating portion" in the invention, the "fourth lead wiring 631" in the embodiment corresponds to an example of the "second lead wiring " in the invention, and the "fourth terminal portion 632" in the embodiment corresponds to an example of the "second terminal portion "in the invention.

The "cover portion 64" in the embodiment corresponds to an example of the "cover portion" in the invention, the "cover layer 65" in the embodiment corresponds to an example of the "cover layer" in the invention, and the "second protruding portion 661" in the embodiment corresponds to an example of the "second protruding portion" in the invention.

The above-described embodiment is used to facilitate the understanding of the invention and does not limit the invention. Thus, the components disclosed in the above-described embodiment include all modifications in design and equivalents belonging to the technical scope of the invention.

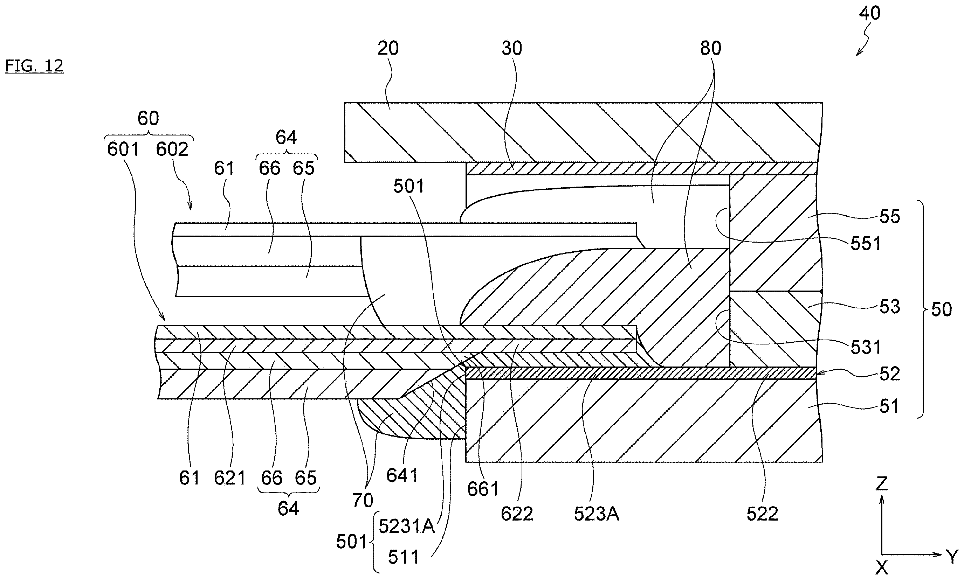

For example, as in the wiring body assembly 40A illustrated in Fig. 12, the first terminal portion 523A may extend to the edge portion 502 of the first wiring body 50A. In this case, the first protruding portion 701 covers a portion of the end surface 5231A of the first terminal portion 523A. Accordingly, it is possible to prevent the first terminal portion 523A from being exposed to the outside air to be deteriorated.

In the above-described embodiment, the cover portion 64 includes the cover layer 65 and the adhesive layer 66. However, as long as the cover portion 64 includes at least the cover layer 65, the adhesive layer 66 may be omitted from the cover portion 64. In this case, a resist material such as an UV curable resin or a thermosetting resin such as an epoxy resin, a urethane resin, a polyester resin, or an acrylic resin may be disposed on the third conductor portion 62 or the fourth conductor portion 63 by using a known printing method, and then, the cover layer 65 may be formed by curing the resist material.

For example, in the embodiment, the second protruding portion 661 of the adhesive layer 66 overlaps the first wiring body 50 in the stacking direction, but the invention is not particularly limited thereto, and the second protruding portion 661 may not overlap the first wiring body 50 in the stacking direction.

In the above-described embodiment, the cover portion 64 includes the cover layer 65 and the adhesive layer 66. However, as long as the cover portion 64 includes at least the cover layer 65, the adhesive layer 66 may be omitted from the cover portion 64. In this case, a resist material such as an UV curable resin or a thermosetting resin such as an epoxy resin, a urethane resin, a polyester resin, or an acrylic resin may be disposed on the third conductor portion 62 or the fourth conductor portion 63 by using a known printing method, and then, the cover layer 65 may be formed by curing the resist material.

For example, the touch sensor of the above-described embodiment is a projection-type capacitive touch sensor using the two-layer conductor portions 52 and 54, but the invention is not particularly limited thereto, and the invention can also be applied to a surface-type (capacitive coupling type) capacitive touch sensor using a single-layer conductor portion.

A mixture of a metal material and a carbon-based material may be used for the first conductor portion 52 and the second conductor portion 54. In this case, for example, a carbon-based material may be disposed on the top surface side of the conductor pattern, and a metal material may be disposed on the contact surface side. Reversely, the metal material may be disposed on the top surface side of the conductor pattern, and the carbon material may be disposed on the contact surface side.

Although not specifically illustrated, it is not particularly limited to the mode in which the first wiring body 50 is attached to the cover panel 20 in the above-described embodiment. For example, the first wiring body may be configured as a mode in which a release sheet is provided on the lower surface of the first resin portion 51, the release sheet is peeled off at the time of mounting, and the first wiring body is adhered and mounted on a mounting object (a film, a surface glass, a polarizing plate, a display glass, or the like). The first wiring body may be configured as a mode where a resin portion covering the first wiring body 50 is further provided from the first resin portion 51 (resin portion) side, and the first wiring body is adhered and mounted on the above-described mounting object via the resin portion. The first wiring body may be configured as a mode where a resin portion covering the first wiring body 50is provided from the third resin portion 55 side, and the first wiring body is adhered and mounted on the above-described mounting object via the resin portion. In these cases, the mounting object on which the wiring body is mounted corresponds to an example of the supporting body of the invention.

Furthermore, in the above-described embodiment, the wiring body assembly has been described as being used for a touch sensor or the like, but the invention is not particularly limited thereto. For example, the first wiring body may be used as a heater by applying electricity to the first wiring body to generate heat by resistance heating or the like. In this case, it is preferable to use a carbon material having a relatively high electric resistance value as the conductive particles of the conductor portion. The first wiring body may be used as the electromagnetic shielding body by grounding a portion of the conductor portion of the first wiring body. The first wiring body may be used as an antenna. In this case, the mounting object on which the first wiring body is mounted corresponds to an example of the supporting body of the invention.

### EXPLANATIONS OF LETTERS OR NUMERALS

- 1: TOUCH SENSOR
- 10: WIRING BOARD
- 20: COVER PANEL
- 21: TRANSPARENT PORTION
- 22: SHIELDING PORTION
- 30: TRANSPARENT ADHESIVE LAYER
- 40: WIRING BODY ASSEMBLY
- Z₁: FIRST CONNECTION REGION
- Z₂: SECOND CONNECTION REGION
- 50: FIRST WIRING BODY
- 501: END SURFACE
- 502: EDGE PORTION
- 51: FIRST RESIN PORTION
- 511: END SURFACE
- 52: FIRST CONDUCTOR PORTION
- 521: FIRST ELECTRODE PORTION
- 522: FIRST LEAD WIRING
- 523: FIRST TERMINAL PORTION
- 5231A: END SURFACE
- 53: SECOND RESIN PORTION
- 531: FIRST NOTCH PORTION
- 532: END SURFACE
- 54: SECOND CONDUCTOR PORTION
- 541: SECOND ELECTRODE PORTION
- 542: SECOND LEAD WIRING
- 543: SECOND TERMINAL PORTION
- 55: THIRD RESIN PORTION
- 551: SECOND NOTCH PORTION
- 60: SECOND WIRING BODY
- 601: FIRST BRANCH PORTION
- 602: SECOND BRANCH PORTION
- 603: SLIT
- 61: SUBSTRATE
- 62: THIRD CONDUCTOR PORTION
- 621: THIRD LEAD WIRING
- 622: THIRD TERMINAL PORTION
- 63: FOURTH CONDUCTOR PORTION
- 631: FOURTH LEAD WIRING
- 632: FOURTH TERMINAL PORTION
- 64: COVER PORTION
- 641: THIRD NOTCH PORTION
- 642: FOURTH NOTCH PORTION
- 65: COVER LAYER
- 66: ADHESIVE LAYER
- 661: SECOND PROTRUDING PORTION
- 70: CONDUCTIVE ADHERING PORTION
- 701: FIRST PROTRUDING PORTION
- 80: SEALING RESIN
- 100: CONDUCTIVE ADHESIVE MATERIAL
- 200: CRIMP HEAD
- 300: CRIMP STAGE

## Claims

1. A wiring body assembly comprising:
a first wiring body including a first insulating portion, a first lead wiring and a first terminal portion, the first lead wiring and the first terminal portion being formed on one surface of the first insulating portion;
a second wiring body including a second insulating portion, a second lead wiring and a second terminal portion, the second lead wiring and the second terminal portion being formed on the other surface of the second insulating portion; and
a conductive adhering portion connecting the first terminal portion and the second terminal portion, wherein
the first wiring body and the second wiring body overlap each other so that the first terminal portion and the second terminal portion face each other via the conductive adhering portion,
the conductive adhering portion includes a first protruding portion protruding from a space between the first wiring body and the second wiring body,
the first protruding portion covers a portion of an end surface of the first wiring body, and
a portion of the end surface of the first wiring body includes at least a region overlapping the second wiring body in a stacking direction of the first wiring body and the second wiring body.

2. The wiring body assembly according to claim 1, wherein
the first protruding portion covers a portion of an end surface of the first insulating portion, and
a portion of the end surface of the first insulating portion includes at least a region overlapping the second wiring body in the stacking direction.

3. The wiring body assembly according to claim 1 or 2, wherein
the second wiring body further includes a cover portion including at least a cover layer formed on the other surface of the second insulating portion so as to cover the second lead wiring, and
the cover layer does not overlap the first wiring body in the stacking direction.

4. The wiring body assembly according to claim 3, wherein the conductive adhering portion is in contact with at least a portion of the cover portion.

5. The wiring body assembly according to claim 4, wherein the first protruding portion is in contact with the cover portion.

6. The wiring body assembly according to claim 5, wherein the first protruding portion covers a portion of the other surface of the cover portion.

7. The wiring body assembly according to any one of claims 3 to 6, wherein
the cover portion includes an adhesive layer interposed between the cover layer and the second lead wiring,
the adhesive layer includes a second protruding portion protruding toward a distal end side of the second wiring body from a distal end of the cover layer, and
the second protruding portion overlaps the first wiring body in the stacking direction.

8. The wiring body assembly according to claim 7, wherein the second protruding portion does not overlap the first terminal portion in the stacking direction.

9. The wiring body assembly according to claim 7 or 8, wherein the conductive adhering portion is in contact with both the cover layer and the adhesive layer.

10. The wiring body assembly according to any one of claims 3 to 9, wherein the cover layer overlaps the first insulating portion in an extending direction of the second wiring body.

11. The wiring body assembly according to any one of claims 1 to 10, wherein
the first terminal portion extends to an edge portion of the first wiring body, and
the first protruding portion covers a portion of an end surface of the first terminal portion.

12. The wiring body assembly according to any one of claims 1 to 11, wherein a material of which the first insulating portion is made includes a resin material having optical isotropy.

13. A wiring board comprising:
the wiring body assembly according to any one of claims 1 to 12; and
a supporting body provided on one surface or the other surface of the first wiring body to support the first wiring body.

14. A touch sensor comprising the wiring board according to claim 13.
